# EUROPEAN PATENT APPLICATION

(11) **EP 4 618 703 A1**
(43) Date of publication of application: **17.09.2025**
(21) Application number: 23896201.3
(22) Date of filing: 13.09.2023
(51) Int. Cl.: H05K 5/02, H05K 7/20, H05K 7/14, H01Q 1/02

(54) **HOUSING, ENERGY PROCESSING DEVICE, AND BASE STATION ANTENNA**

(30) Priority: 28.11.2022 CN 202211504444
(71) Applicant: Huawei Technologies Co., Ltd., Shenzhen, Guangdong 518129 (CN)
(72) Inventor: LIU, Xinming, Shenzhen, Guangdong 518129 (CN); GUO, Bingjun, Shenzhen, Guangdong 518129 (CN); LEI, Fuwei, Shenzhen, Guangdong 518129 (CN); LIU, Xianfeng, Shenzhen, Guangdong 518129 (CN); WANG, Enpu, Shenzhen, Guangdong 518129 (CN)
(74) Representative: Gill Jennings & Every LLP
(86) International application number: PCT/CN2023/118616
(87) International publication number: WO 2024/114044

(57) **Abstract**

A housing (1), an energy processing apparatus, and a base station antenna are provided. The housing (1) includes at least one accommodation cavity (15), the accommodation cavity (15) is for disposing a circuit board (2), side walls of the accommodation cavity (15) are provided with a plurality of through holes (11), and a total area of through holes (11) on any side wall of the accommodation cavity (15) is not less than 1/2 of an area of the side wall; and mounting holes are provided on the side wall of the accommodation cavity (15), and the mounting holes are used to allow the input port (3) and the output port (4) to pass through. The through holes (11) in communication with the accommodation cavity (15) are provided on the side wall of the housing (1), so that heat generated by a component such as the circuit board (2) in the accommodation cavity (15), which is a heat generating device, can be dissipated to the outside of the housing (1) via the through holes (11), to avoid heat accumulation in the accommodation cavity (15). The total area of the through holes (11) on the side wall is greater than or equal to half the area of the side wall, so that effective heat dissipation of internal heat of the accommodation cavity (15) can be achieved, and when a large quantity of phase shifters, power splitters, or filters are used, a problem of excessive heat accumulation affecting performance of the base station antenna does not occur.

## Description

The present invention claims priority to Chinese Patent Application No. 202211504444.X, filed with the China National Intellectual Property Administration on November 28, 2022 and entitled "HOUSING, ENERGY PROCESSING APPARATUS, AND BASE STATION ANTENNA", which is incorporated herein by reference in its entirety.

### TECHNICAL FIELD

This application relates to the field of communication technologies, and in particular, to a housing, an energy processing apparatus, and a base station antenna.

### BACKGROUND

An existing power splitter plays an important role in an antenna such as a remote electrical tilt antenna. However, with an increase in antenna frequency bands, especially with application of multi-port input/output of a 5G antenna, a quantity of power splitters gradually increases. Because a shell of the power splitter is usually a closed surface, heat dissipation performance of each power splitter is affected due to aggregation of a large quantity of power splitters, and reliability of an entire base station antenna is further affected.

### SUMMARY

An objective of this application is to provide a housing, an energy processing apparatus, and a base station antenna, to resolve a problem of poor heat dissipation performance of a power splitter in conventional technologies.

According to a first aspect of this application, a housing is provided, where the housing includes at least one accommodation cavity, the accommodation cavity is for disposing a circuit board, side walls of the accommodation cavity are provided with a plurality of through holes, and a total area of through holes on any side wall of the accommodation cavity is not less than 1/2 of an area of the side wall; and mounting holes are provided on the side wall of the accommodation cavity, and the mounting holes are used to allow an input port and an output port to pass through.

In the housing provided in this application, the through holes in communication with the accommodation cavity are provided on the side wall of the housing, so that heat generated by a component such as the circuit board in the accommodation cavity, which is a heat generating device, can be dissipated to the outside of the housing via the through holes, to avoid heat accumulation in the accommodation cavity. The total area of the through holes on the side wall needs to be greater than or equal to half the area of the side wall, so that effective heat dissipation of internal heat of the accommodation cavity can be achieved, and when a large quantity of phase shifters, power splitters, or filters are used, a problem of excessive heat accumulation affecting performance of the base station antenna does not occur.

In a possible design, the housing includes a top plate, a bottom plate, and a side plate, the top plate, the bottom plate, and the side plate enclose to form the accommodation cavity, and the mounting holes are provided on the side plate; at least one of the top plate, the bottom plate, and the side plate is provided with the through hole; and center lines of at least a part of through holes on the top plate or the bottom plate intersect with center lines of the mounting holes. Therefore, after the input port and the output port pass through the mounting holes, positions at which the input port and the output port are separately connected to the circuit board can be determined based on the portion of the through holes of which the center lines intersect with the center lines of the mounting holes, so that the input port and the output port can be conveniently welded to the circuit board via these through holes.

In a possible design, the through holes are distributed in an array on at least one side wall of the accommodation cavity, and N+1 rows of through holes are arranged along a length direction of the housing, where N is a total quantity of the mounting holes; and M rows of through holes are arranged along a width direction of the housing, where M is greater than or equal to 2. A quantity of rows of the through holes provided in the length direction of the housing is greater than a quantity of mounting holes, so that the center lines of the portion of the through holes can intersect with the center lines of the mounting holes, so that the input port and the output port can be welded to the circuit board via the through holes. In addition, a quantity of rows of the through holes in the width direction of the housing is greater than 2, so that a large quantity of through holes can be provided, thereby improving a heat dissipation effect.

In a possible design, the housing includes a bottom plate and a side plate, the bottom plate and the side plate enclose to form the accommodation cavity, a side that is of the accommodation cavity and that is away from the bottom plate is open, and the mounting holes are provided on the side plate; and at least one side of the bottom plate and the side plate is provided with the through hole.

The bottom plate and the side plate may enclose to form a groove-shaped structure, and the accommodation cavity is formed in the groove, to be specific, one side of the accommodation cavity is in an open state and is not blocked by a top plate. This is more conducive to heat diffusion of a heat generating device such as the circuit board in the accommodation cavity. In addition, the circuit board may be mounted from the open side of the accommodation cavity, thereby facilitating a mounting operation of the circuit board, and also facilitating a welding operation of welding the input port and the output port to the circuit board.

In a possible design, the housing includes two accommodation cavities, and the two accommodation cavities are not connected to each other.

A circuit board may be disposed in each accommodation cavity, and a corresponding input port and output port are connected to the circuit board, so that each accommodation cavity can form a radio frequency transmission region, and each accommodation cavity can correspond to one polarization channel, to implement dual polarization of an antenna.

In a possible design, the accommodation cavity is formed by using a sheet metal bending process.

Before the housing is manufactured, an entire flat sheet material may be used, and the through hole may be pre-made on the sheet material. Then, the sheet material may be bent into a set shape by using the sheet metal bending process, to form one or more accommodation cavities. In addition, when a plurality of accommodation cavities are formed by bending, a portion of the sheet material may be bent between two adjacent accommodation cavities, to separate the two adjacent accommodation cavities.

In a possible design, the through hole is formed by using a stamping process or a sheet metal stretching process.

Before the housing is manufactured, an entire flat sheet material may be used, and the through hole may be formed on the sheet material by using the stamping process. After the sheet material is bent, each side wall of the housing may be provided with the through hole. In addition, a sheet metal with a fine slit may alternatively be used. The sheet metal may be first stretched into a sheet material of a specific size by using the sheet metal stretching process. In a process of stretching the sheet metal, the fine slit on the sheet metal may be stretched into a hole shape to form the through hole. Then, the sheet material obtained by stretching may be bent to form the housing.

In a possible design, a shape of the through hole is a round hole, a square hole, a hexagonal hole, a diamond-shaped hole, an abnormal-shaped hole, or an elongated obround hole.

In a possible design, the through holes are non-evenly distributed on the side wall of the accommodation cavity. To be specific, the through holes may be provided in a centralized manner in some regions of the side wall of the housing, or may be provided in a distributed manner in some regions of the side wall of the housing. Specifically, the through holes may be densely arranged on a main heat generating region on the side wall of the housing corresponding to the circuit board and the heat generating device, while the through holes may be arranged with lower density in a non-main heat generating region, so that good through hole density can be matched based on a heat distribution situation inside the accommodation cavity, thereby achieving a good heat dissipation effect.

In a possible design, the through holes are evenly distributed on the side wall of the accommodation cavity in a staggered manner, thereby facilitating uniform heat dissipation at each position of the side wall.

In a possible design, a protrusion structure used to support the circuit board is provided on an inner wall of the housing. The circuit board may be supported on the protrusion structure, to facilitate mounting and fastening of the circuit board.

According to a second aspect of this application, an energy processing apparatus is further provided, including a circuit board, an input port, an output port, and the housing provided in the first aspect of this application, where the circuit board is disposed in the accommodation cavity, the input port is connected to the circuit board via the mounting hole, and the output port is connected to the circuit board via the mounting hole.

The energy processing apparatus that uses the housing has a same technical effect as the housing, and details are not described herein again.

In a possible design, the energy processing apparatus is a phase shifter, a power splitter, or a filter.

According to a third aspect of this application, a base station antenna is further provided, including the energy processing apparatus provided in the second aspect of this application.

It is to be understood that the foregoing general descriptions and the following detailed descriptions are merely used as an example, and do not limit this application.

### BRIEF DESCRIPTION OF DRAWINGS

FIG. 1 is a diagram of a structure of an energy processing apparatus according to an embodiment of this application;
FIG. 2 is a diagram of a structure of a housing according to an embodiment of this application;
FIG. 3 is a diagram of a structure of an energy processing apparatus according to another embodiment of this application;
FIG. 4 is a diagram of a housing according to another embodiment of this application;
FIG. 5 is a diagram of a structure of an energy processing apparatus according to still another embodiment of this application;
FIG. 6 is a diagram of a housing according to still another embodiment of this application;
FIG. 7 is a diagram of a structure of a housing formed by using a bending process according to an embodiment of this application;
FIG. 8 is a diagram of a structure of a housing formed by using a bending process according to another embodiment of this application;
FIG. 9 is a front view of a sheet material according to an embodiment of this application; and
FIG. 10 is a front view of a sheet material according to another embodiment of this application.

### Reference numerals:

1-Housing;
   11-Through hole;
   12-Top plate;
   13-Bottom plate;
   14-Side plate;
   15-Accommodation cavity;
   16-Protrusion structure;
2-Circuit board;
3-Input port;
4-Output port;
5-Dielectric pull-rod;
6-Sliding dielectric; and
7-Sheet material.

The accompanying drawings herein are incorporated into this specification and constitute a part of this specification, to show embodiments in accordance with this application, and are used, together with this specification, to explain the principle of this application.

### DESCRIPTION OF EMBODIMENTS

To better understand technical solutions of this application, the following describes embodiments of this application in detail with reference to the accompanying drawings. It is to be understood that the specific embodiments described herein are merely used to explain this application but are not intended to limit this application.

In descriptions of this application, unless otherwise specified and limited, the terms "first" and "second" are merely intended for a purpose of description, and are not to be understood as an indication or implication of relative importance. Unless otherwise specified or stated, the term "a plurality of" means two or more. The terms "connection", "fastening" and the like is to be understood in a broad sense. For example, the "connection" may be a fastened connection, or may be a detachable connection, an integrated connection, or an electrical connection, or may be a direct connection, or may be an indirect connection by using an intermediate medium. A person of ordinary skill in the art may understand the specific meanings of the foregoing terms in this application based on specific situations.

An existing power splitter plays an important role in an antenna such as a remote electrical tilt antenna. A shell of the existing power splitter is usually a closed surface, and heat is accumulated inside the power splitter. When only one power splitter is used in a base station antenna to work independently, impact of heat accumulated inside the power splitter on the base station antenna is not significant. However, with an increase in antenna frequency bands, especially with application of multi-port input/output of a 5G antenna, a quantity of power splitters gradually increases. Consequently, impact of heat accumulated inside the power splitters on the base station antenna is amplified, in other words, a sum of heat accumulated in all the power splitters is very large. If the heat cannot be dissipated in a timely manner, reliability of the entire base station antenna is adversely affected.

An embodiment of this application provides a housing 1. The housing 1 may be used in an energy processing apparatus. The energy processing apparatus may be but is not limited to a phase shifter, a power splitter, and a filter. The housing 1 may be used as a shell of the phase shifter, the power splitter, and the filter. Certainly, the energy processing apparatus may altematively be another apparatus that can process a signal, an electromagnetic wave, or the like and that has a heat dissipation requirement for the housing 1.

The energy processing apparatus may be used in a base station antenna. For example, when the energy processing apparatus is used in a base station antenna remote electrical tilt antenna as a phase shifter, the phase shifter adjusts a downtilt angle of an antenna beam by changing a relative phase between antenna units, to implement downtilt adjustment of a beam of the base station antenna. This has advantages such as a wide downtilt adjustment range, high precision, good pattern control, a strong anti-interference capability, and easy control. When the energy processing apparatus is used in a base station antenna as a power splitter, the power splitter may split energy of one channel of input signals into two or more channels for output with equal or unequal signal energy, or may combine energy of a plurality of channels of signals into one channel for output. When used in a base station antenna as a filter, the energy processing apparatus may effectively filter out a frequency of a specific frequency or a frequency other than the frequency in a power cable, to obtain a power signal of the specific frequency, or a power signal from which the specific frequency is eliminated.

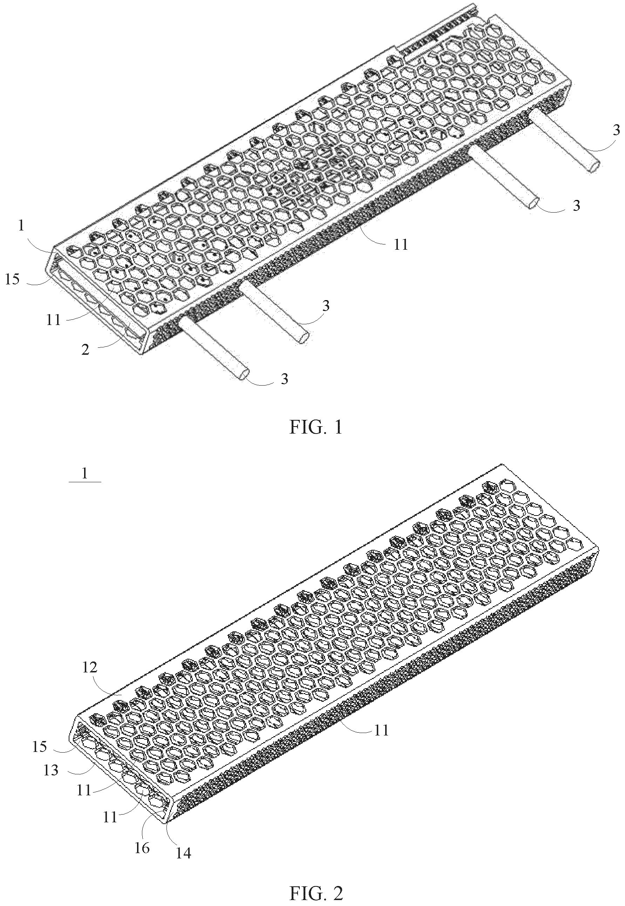

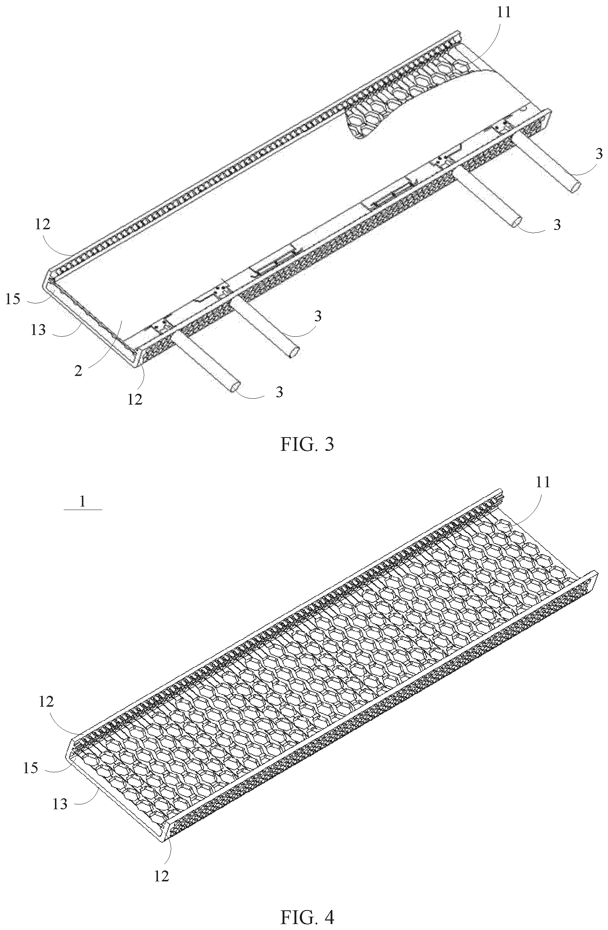

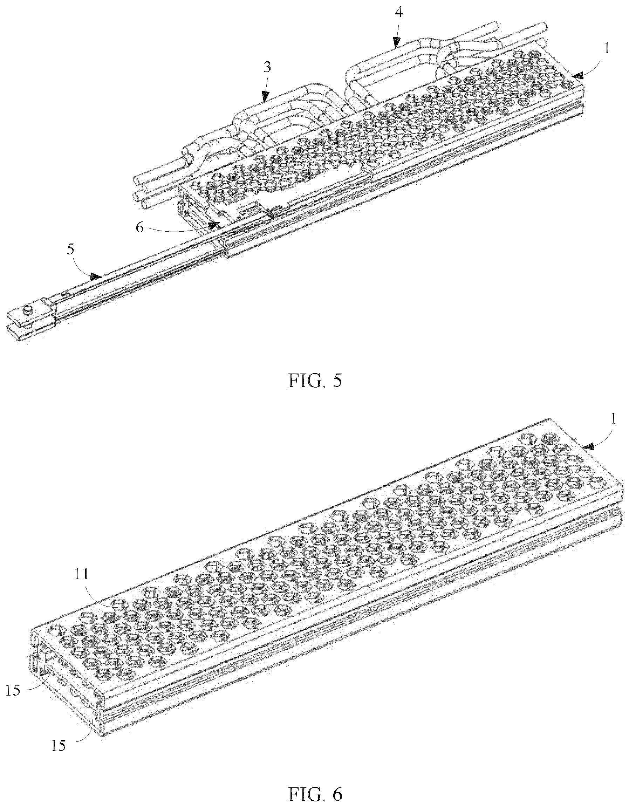

The energy processing apparatus includes a circuit board 2, an input port 3, an output port 4, and the housing 1 provided in this embodiment. FIG. 1 is a diagram of a structure of an energy processing apparatus according to an embodiment of this application. FIG. 3 is a diagram of a structure of an energy processing apparatus according to another embodiment of this application. The energy processing apparatuses shown in FIG. 1 and FIG. 3 may be power splitters. FIG. 5 is a diagram of a structure of an energy processing apparatus according to still another embodiment of this application. The energy processing apparatus shown in FIG. 5 may be a phase shifter. The phase shifter includes a housing 1, a circuit board 2, an input port 3, an output port 4, a dielectric pull-rod 5, and a sliding dielectric 6. The sliding dielectric 6 may be driven to move by driving the dielectric pull-rod 5, to implement phase adjustment.

Specifically, FIG. 2 is a diagram of a structure of a housing according to an embodiment of this application. As shown in FIG. 2, the housing 1 includes at least one accommodation cavity 15, the accommodation cavity 15 is for disposing a circuit board 2, side walls of the accommodation cavity 15 are provided with a plurality of through holes 11, and a total area of through holes 11 on any side wall of the accommodation cavity 15 is not less than 1/2 of an area of the side wall; and mounting holes are provided on the side wall of the accommodation cavity 15, and the mounting holes are used to allow an input port 3 and an output port 4 to pass through. The input port 3 and the output port 4 may be connected to the circuit board 2 to implement signal input or output.

FIG. 2 is a diagram of a structure of a housing according to an embodiment of this application. As shown in FIG. 2, the accommodation cavity 15 is of a hollow structure, so that the circuit board 2 can be mounted in internal space of the accommodation cavity 15. The accommodation cavity 15 may be of a square, trapezoidal, polygonal, or abnormal-shaped structure. This embodiment is described by using an example in which the accommodation cavity 15 is of a rectangular shape. The accommodation cavity 15 may have a plurality of side walls, and at least one side wall of the plurality of side walls may be provided with a plurality of through holes 11. To be specific, only one side wall may be provided with the through holes 11, or two, three, or all side walls may be provided with the through holes 11. The through hole 11 may communicate with the accommodation cavity 15. A component such as the circuit board 2 in the accommodation cavity 15 is a heat generating device, and heat generated by the component may be dissipated to the outside of the housing 1 via the through holes 11, to avoid heat accumulation in the accommodation cavity 15.

However, if a heat dissipation area of the through holes 11 is small, a good heat dissipation effect cannot be achieved. In a case that a quantity of phase shifters, power splitters, or filters is large, a large amount of heat is also easily accumulated, resulting in poor performance of a base station antenna. Therefore, in this embodiment, a total area of through holes 11 on any side wall of the accommodation cavity 15 is not less than 1/2 of an area of the side wall. For ease of description, an example in which the accommodation cavity 15 is of the rectangular shape is still used for description. The rectangular accommodation cavity 15 has long edges, wide edges, and height edges. Any side wall of the accommodation cavity 15 may be a side wall formed by long edges and wide edges, or may be a side wall formed by long edges and height edges.

A side wall formed by long edges and wide edges is used as an example. The side wall is provided with a plurality of through holes 11. "A total area of through holes 11" refers to a sum of projection areas of the through holes 11 in through directions of the through holes 11, and "an area of the side wall" refers to an area of a rectangle formed by the long edges and the wide edges. Certainly, when a side wall formed by long edges and height edges is provided with through holes 11, "an area of the side wall" refers to an area of a rectangle formed by the long edges and the high edges. In other words, when any side wall is provided with through holes 11, a total area of the through holes 11 on the side wall needs to be greater than or equal to half the area of the side wall, so that effective heat dissipation of internal heat of the accommodation cavity 15 can be achieved, and when a large quantity of phase shifters, power splitters, or filters are used, a problem of excessive heat accumulation affecting performance of the base station antenna does not occur.

As a specific implementation, as shown in FIG. 2, the housing 1 includes a top plate 12, a bottom plate 13, and a side plate 14. The top plate 12, the bottom plate 13, and the side plate 14 enclose to form the accommodation cavity 15. The top plate 12, the bottom plate 13, and the side plate 14 may enclose to form a rectangular or square accommodation cavity 15, and certainly may altematively enclose to form a trapezoidal accommodation cavity 15, a parallelogram accommodation cavity 15, or an accommodation cavity 15 with another shape.

The mounting holes are provided on the side plate 14, and a quantity of mounting holes may correspond to a quantity of input ports 3 and output ports 4 that need to be disposed. For example, when there are two input ports 3 and two output ports 4, four mounting holes may be provided. Two mounting holes may be used for mounting the input ports 3, and the other two mounting holes may be used for mounting the output ports 4. When there are four input ports 3 and four output ports 4, eight mounting holes may be provided. Four mounting holes may be used for mounting the input ports 3, and the other four mounting holes may be used for mounting the output ports 4. The mounting holes may be arranged in a line shape, or may be arranged in multiple rows and multiple columns in an array form. Specifically, the mounting holes may be designed based on an arrangement form of the input port 3 and the output port 4.

At least one of the top plate 12, the bottom plate 13, and the side plate 14 is provided with the through hole 11, and center lines of at least a part of through holes 11 on the top plate 12 or the bottom plate 13 intersect with center lines of the mounting holes. It may be understood that, the top plate 12 is adjacent to the side plate 14. When the top plate 12, the bottom plate 13, and the side plate 14 enclose to form a cuboid accommodation cavity 15, the top plate 12 and the side plate 14 are perpendicularly disposed, and a through direction of a through hole 11 on the top plate 12 is also perpendicular to a through direction of a mounting hole on the side plate 14. The center lines of the portion of the through holes 11 intersect with the center lines of the mounting holes. Therefore, after the input port 3 and the output port 4 pass through the mounting holes, positions at which the input port 3 and the output port 4 are separately connected to the circuit board 2 can be determined based on the portion of the through holes 11 of which the center lines intersect with the center lines of the mounting holes, so that the input port 3 and the output port 4 can be conveniently welded to the circuit board 2 via these through holes 11.

In this embodiment, no side plates 14 are provided at two ends in a length direction of the housing 1, so that the accommodation cavity 15 is through in the length direction of the housing 1. Therefore, the circuit board 2 can be easily mounted in the accommodation cavity 15 from either side of the two sides in the length direction of the housing 1, and this also facilitates heat diffusion.

As a specific implementation, the through holes 11 are distributed in an array on at least one side wall of the accommodation cavity 15, and N+1 rows of through holes 11 are arranged along a length direction of the housing 1, where N is a total quantity of the mounting holes; and M rows of through holes 11 are arranged along a width direction of the housing 1, where M is greater than or equal to 2.

Based on the through holes 11 distributed in an array, uniform heat dissipation at each position of the housing 1 can be implemented, thereby improving a heat dissipation effect. In addition, after being mounted in the mounting holes, the input port 3 and the output port 4 need to be further welded to the circuit board 2. Therefore, a quantity of rows of the through holes 11 provided in the length direction of the housing 1 is greater than a quantity of mounting holes, so that the center lines of the portion of the through holes 11 can intersect with the center lines of the mounting holes, so that the input port 3 and the output port 4 can be welded to the circuit board 2 via the through holes 11. In addition, a quantity of rows of the through holes 11 in the width direction of the housing 1 is greater than 2, so that a large quantity of through holes 11 can be provided, thereby improving a heat dissipation effect.

FIG. 4 is a diagram of a housing according to another embodiment of this application. As shown in FIG. 4, a housing 1 includes a bottom plate 13 and a side plate 14, the bottom plate 13 and the side plate 14 enclose to form an accommodation cavity 15, a side that is of the accommodation cavity 15 and that is away from the bottom plate 13 is open, and mounting holes are provided on the side plate 14; and at least one side of the bottom plate 13 and the side plate 14 is provided with the through hole 11.

In this embodiment, the bottom plate 13 and the side plate 14 may enclose to form a groove-shaped structure, and the accommodation cavity 15 is formed in the groove, to be specific, one side of the accommodation cavity 15 is in an open state and is not blocked by a top plate 12. This is more conducive to heat diffusion of a heat generating device such as the circuit board 2 in the accommodation cavity 15. In addition, the circuit board 2 may be mounted from the open side of the accommodation cavity 15, thereby facilitating a mounting operation of the circuit board 2, and also facilitating a welding operation of welding the input port 3 and the output port 4 to the circuit board 2.

FIG. 6 is a diagram of a housing according to still another embodiment of this application. As shown in FIG. 6, a housing 1 includes two accommodation cavities 15, and the two accommodation cavities 15 are not connected to each other. A circuit board 2 may be disposed in each accommodation cavity 15, and a corresponding input port 3 and output port 4 are connected to the circuit board 2, so that each accommodation cavity 15 can form a radio frequency transmission region, and each accommodation cavity 15 can correspond to one polarization channel, to implement dual polarization of an antenna.

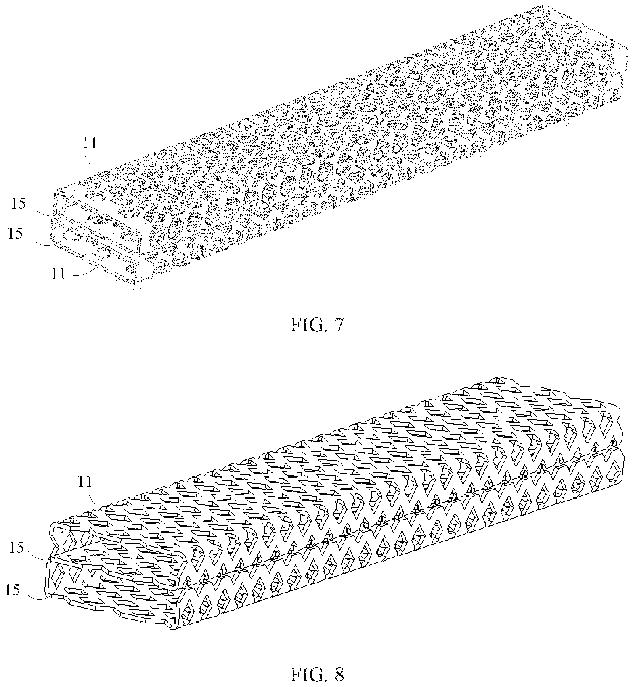

FIG. 7 is a diagram of a structure of a housing formed by using a bending process according to an embodiment of this application. FIG. 8 is a diagram of a structure of a housing formed by using a bending process according to another embodiment of this application. As shown in FIG. 7 and FIG. 8, the accommodation cavity 15 is formed by using a sheet metal bending process. Before the housing 1 is manufactured, an entire flat sheet material 7 may be used, and the through hole 11 may be pre-made on the sheet material 7. Then, the sheet material 7 may be bent into a set shape by using the sheet metal bending process, to form one or more accommodation cavities 15. In addition, when a plurality of accommodation cavities 15 are formed by bending, a portion of the sheet material 7 may be bent between two adjacent accommodation cavities 15, to separate the two adjacent accommodation cavities 15.

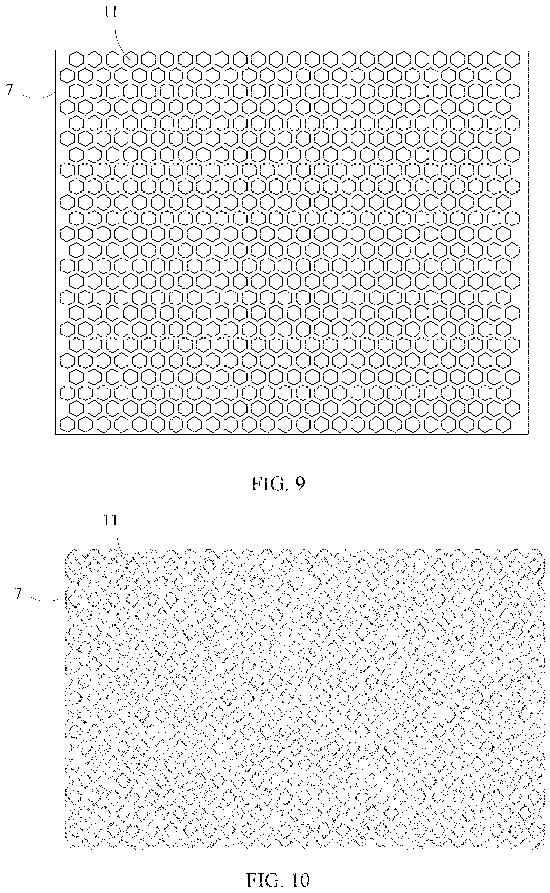

As a specific implementation, the through hole 11 is formed by using a stamping process or a sheet metal stretching process. FIG. 9 is a front view of a sheet material according to an embodiment of this application. As shown in FIG. 9, before the housing 1 is manufactured, an entire flat sheet material 7 may be used, and the through hole 11 may be formed on the sheet material 7 by using the stamping process. After the sheet material 7 is bent, each side wall of the housing 1 may be provided with the through hole 11. In addition, FIG. 10 is a front view of a sheet material according to another embodiment of this application. As shown in FIG. 10, a sheet metal with a fine slit may altematively be used. The sheet metal may be first stretched into a sheet material 7 of a specific size by using the sheet metal stretching process. In a process of stretching the sheet metal, the fine slit on the sheet metal may be stretched into a hole shape to form the through hole 11. Then, the sheet material 7 obtained by stretching may be bent to form the housing 1.

Through holes 11 of various shapes, such as a round hole, a square hole, a hexagonal hole, a diamond-shaped hole, an abnormal-shaped hole, or an elongated obround hole, may be stamped on the sheet material 7 by using the stamping process. The through hole shown in FIG. 9 is a hexagonal hole, and certainly may alternatively be of another shape. As shown in FIG. 10, the sheet metal stretching process is used. Because the fine slit on the sheet material needs to be stretched into a hole under stretching force, a shape of the hole is usually a diamond shape, and certainly, the hole may alternatively be an abnormal-shaped hole.

As a specific implementation, the through holes 11 are non-evenly distributed on the side wall of the accommodation cavity 15. To be specific, the through holes 11 may be provided in a centralized manner in some regions of the side wall of the housing 1, or may be provided in a distributed manner in some regions of the side wall of the housing 1. Specifically, the through holes 11 may be densely arranged on a main heat generating region on the side wall of the housing 1 corresponding to the circuit board 2 and the heat generating device, while the through holes 11 may be arranged with lower density in a non-main heat generating region, so that good through hole 11 density can be matched based on a heat distribution situation inside the accommodation cavity 15, thereby achieving a good heat dissipation effect.

As a specific implementation, the through holes 11 are evenly distributed on the side wall of the accommodation cavity 15 in a staggered manner, thereby facilitating uniform heat dissipation at each position of the side wall. For example, as shown in FIG. 7, the through holes 11 may be hexagonal, and some of the through holes 11 may be distributed in a staggered manner, so that the side wall of the housing 1 forms a honeycomb shape, thereby facilitating uniform heat dissipation.

As a specific implementation, as shown in FIG. 2, a protrusion structure used to support the circuit board 2 is provided on an inner wall of the housing 1. The circuit board 2 may be supported on the protrusion structure, to facilitate mounting and fastening of the circuit board 2. A slide groove may also be provided on the inner wall of the housing 1, and the circuit board 2 may be connected to the slide groove. Certainly, the circuit board 2 may altematively be mounted and fastened in another manner. This is not limited in this embodiment.

The foregoing descriptions are merely preferred embodiments of this application, and are not intended to limit this application. For a person skilled in the art, this application may have various modifications and variations. Any modification, equivalent replacement, improvement, and the like made within the spirit and principle of this application shall fall within the protection scope of this application.

## Claims

1. A housing, wherein the housing comprises at least one accommodation cavity, the accommodation cavity is for disposing a circuit board, side walls of the accommodation cavity are provided with a plurality of through holes, and a total area of through holes on any side wall of the accommodation cavity is not less than 1/2 of an area of the side wall; and
mounting holes are provided on the side wall of the accommodation cavity, and the mounting holes are used to allow an input port and an output port to pass through.

2. The housing according to claim 1, wherein the housing comprises a top plate, a bottom plate, and a side plate, the top plate, the bottom plate, and the side plate enclose to form the accommodation cavity, and the mounting holes are provided on the side plate;
at least one of the top plate, the bottom plate, and the side plate is provided with the through hole; and
center lines of at least a part of through holes on the top plate or the bottom plate intersect with center lines of the mounting holes.

3. The housing according to claim 2, wherein the through holes are distributed in an array on at least one side wall of the accommodation cavity, and N+1 rows of through holes are arranged along a length direction of the housing, wherein N is a total quantity of the mounting holes; and M rows of through holes are arranged along a width direction of the housing, wherein M is greater than or equal to 2.

4. The housing according to claim 1, wherein the housing comprises a bottom plate and a side plate, the bottom plate and the side plate enclose to form the accommodation cavity, a side that is of the accommodation cavity and that is away from the bottom plate is open, and the mounting holes are provided on the side plate; and
at least one side of the bottom plate and the side plate is provided with the through hole.

5. The housing according to claim 1, wherein the housing comprises two accommodation cavities, and the two accommodation cavities are not connected to each other.

6. The housing according to any one of claims 1 to 5, wherein the accommodation cavity is formed by using a sheet metal bending process.

7. The housing according to any one of claims 1 to 5, wherein the through hole is formed by using a stamping process or a sheet metal stretching process.

8. The housing according to any one of claims 1 to 7, wherein a shape of the through hole is a round hole, a square hole, a hexagonal hole, a diamond-shaped hole, an abnormal-shaped hole, or an elongated obround hole.

9. The housing according to claim 1 or 2, wherein the through holes are non-evenly distributed on the side wall of the accommodation cavity.

10. The housing according to claim 1 or 2, wherein the through holes are evenly distributed in a staggered manner on the side wall of the accommodation cavity.

11. The housing according to any one of claims 1 to 10, wherein a protrusion structure used to support the circuit board is provided on an inner wall of the housing.

12. An energy processing apparatus, comprising a circuit board, an input port, an output port, and the housing according to any one of claims 1 to 11, wherein the circuit board is disposed in the accommodation cavity, the input port is connected to the circuit board via the mounting hole, and the output port is connected to the circuit board via the mounting hole.

13. The energy processing apparatus according to claim 12, wherein the energy processing apparatus is a phase shifter, a power splitter, or a filter.

14. A base station antenna, comprising the energy processing apparatus according to claim 12 or 13.
